# EUROPEAN PATENT APPLICATION

(11) **EP 3 575 258 A1**
(43) Date of publication of application: **04.12.2019**
(21) Application number: 18175223.9
(22) Date of filing: 30.05.2018
(51) Int. Cl.: B66B 5/00

(54) **WIRELESS SENSOR FOR CONVEYANCE SYSTEM MONITORING**

(71) Applicant: Otis Elevator Company, Farmington, Connecticut 06032 (US)
(72) Inventor:
(74) Representative: Schmitt-Nilson Schraud Waibel Wohlfrom Patentanwälte Partnerschaft mbB

(57) **Abstract**

A sensing apparatus for monitoring a conveyance system is provided. The sensing apparatus including: at least one sensor configured to detect sensor data of the conveyance system; a controller configured to process the sensor data; and a communication module in communication with the controller, the communication module being configured to transmit processed sensor data to a remote device.

## Description

### BACKGROUND

The embodiments herein relate to the field of conveyance systems, and specifically to a method and apparatus for monitoring a conveyance system.

Conveyance systems, such as, for example, elevator systems, escalator systems, and moving walkways may require periodic monitoring to perform diagnostics, which requires a technician to be called and perform a manual inspection of the system in the field.

### BRIEF SUMMARY

According to an embodiment, a sensing apparatus for monitoring a conveyance system is provided. The sensing apparatus including: at least one sensor configured to detect sensor data of the conveyance system; a controller configured to process the sensor data; and a communication module in communication with the controller, the communication module being configured to transmit processed sensor data to a remote device.

In addition to one or more of the features described herein, or as an alternative, further embodiments may include that the at least one sensor further includes: an inertial measurement unit sensor configured to detect sensor data including at least one of power, current, and voltage of a component of the conveyance system.

In addition to one or more of the features described herein, or as an alternative, further embodiments may include: an attachment mechanism configured to removably attach the sensing apparatus to a conveyance system.

In addition to one or more of the features described herein, or as an alternative, further embodiments may include that the at least one sensor further include: an electrical sensor configured to detect sensor data including at least one of power, current, and voltage of a component of the conveyance system.

In addition to one or more of the features described herein, or as an alternative, further embodiments may include that the attachment mechanism is a magnet.

In addition to one or more of the features described herein, or as an alternative, further embodiments may include: a power source configured to provide electrical power to the sensing apparatus or to generate power for the sensing apparatus.

In addition to one or more of the features described herein, or as an alternative, further embodiments may include that the communication module is configured to communicate with the remote device through a local gateway device, and the communication module is configured to communicate with the local gateway device via short-range wireless protocols.

In addition to one or more of the features described herein, or as an alternative, further embodiments may include that the communication module is configured to communicate with the remote device via long-range wireless protocols.

According to another embodiment, a sensing system for monitoring a conveyance system is provided. The sensing system including: a conveyance apparatus of the conveyance system; and a sensing apparatus removably attached to the conveyance apparatus, the sensing apparatus including: a sensor configured to detect sensor data of the conveyance system; a controller configured to process the sensor data; and a communication module in communication with the controller, the communication module being configured to transmit processed sensor data to a remote device.

In addition to one or more of the features described herein, or as an alternative, further embodiments may include that the at least one sensor further includes: an inertial measurement unit sensor configured to detect sensor data including at least one of power, current, and voltage of a component of the conveyance system.

In addition to one or more of the features described herein, or as an alternative, further embodiments may include that the sensing apparatus further includes: an attachment mechanism configured to removably attach the sensing apparatus to a conveyance system.

In addition to one or more of the features described herein, or as an alternative, further embodiments may include that the conveyance system is an elevator system and the conveyance apparatus is an elevator car.

In addition to one or more of the features described herein, or as an alternative, further embodiments may include that the attachment mechanism is configured to removably attach the sensing apparatus to a door of the elevator car of the elevator system.

In addition to one or more of the features described herein, or as an alternative, further embodiments may include that the attachment mechanism is configured to removably attach the sensing apparatus to a door hanger of a door of the elevator car of the elevator system.

In addition to one or more of the features described herein, or as an alternative, further embodiments may include that the conveyance system is an escalator system and the conveyance apparatus is a moving stair of the escalator system.

In addition to one or more of the features described herein, or as an alternative, further embodiments may include that the at least one sensor further includes: an electrical sensor configured to detect sensor date including at least one of power, current, and voltage of a component of the conveyance system.

In addition to one or more of the features described herein, or as an alternative, further embodiments may include that the attachment mechanism is a magnet.

In addition to one or more of the features described herein, or as an alternative, further embodiments may include that the communication module is configured to communicate with the remote device through a local gateway device, and the communication module is configured to communicate with the local gateway device via short-range wireless protocols.

In addition to one or more of the features described herein, or as an alternative, further embodiments may include that the communication module is configured to communicate with the remote device via long-range wireless protocols.

According to another embodiment, a method of monitoring a conveyance system is provided. The method including: removably attaching a sensing apparatus to a conveyance apparatus of a conveyance system using an attachment mechanism; detecting sensor data of the sensing apparatus using a sensor; processing the sensor data using a controller of the sensing apparatus; and transmitting processed sensor data to a remote device using a communication module.

Technical effects of embodiments of the present disclosure include removably attaching a sensing apparatus to a conveyance apparatus of a conveyance system to detect sensor data of the conveyance apparatus, process the sensor data, and transmit the processed sensor data to a remote user device.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The present disclosure is illustrated by way of example and not limited in the accompanying figures in which like reference numerals indicate similar elements.
FIG. 1 is a schematic illustration of an elevator system that may employ various embodiments of the present disclosure;
FIG. 2 is a schematic illustration of a sensor system for the elevator system of FIG. 1, in accordance with an embodiment of the disclosure;
FIG. 3 is a schematic illustration of the location of sensing apparatus of the sensor system of FIG. 2, in accordance with an embodiment of the disclosure;
FIG. 4 illustrates a block diagram of a sensing apparatus of the sensing system of FIG. 2, in accordance with an embodiment of the disclosure; and
FIG. 5 is a flow chart of a method of monitoring a conveyance system, in accordance with an embodiment of the disclosure.

### DETAILED DESCRIPTION

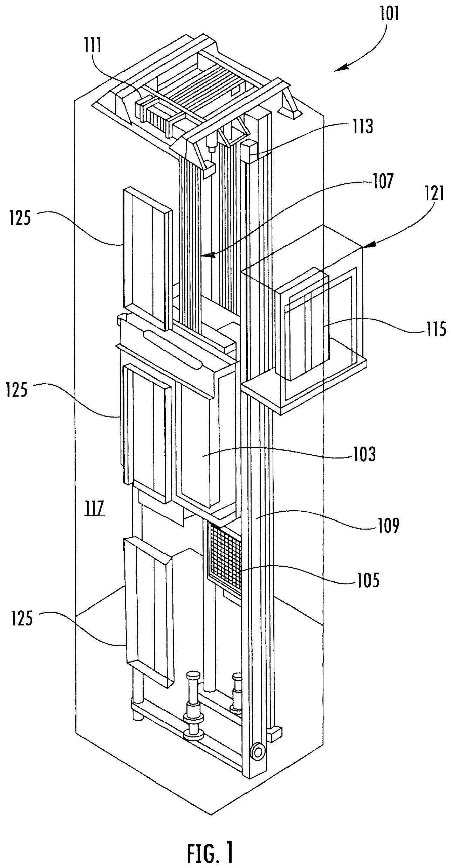

FIG. 1 is a perspective view of an elevator system 101 including an elevator car 103, a counterweight 105, a tension member 107, a guide rail 109, a machine 111, a position reference system 113, and a controller 115. The elevator car 103 and counterweight 105 are connected to each other by the tension member 107. The tension member 107 may include or be configured as, for example, ropes, steel cables, and/or coated-steel belts. The counterweight 105 is configured to balance a load of the elevator car 103 and is configured to facilitate movement of the elevator car 103 concurrently and in an opposite direction with respect to the counterweight 105 within an elevator shaft 117 and along the guide rail 109.

The tension member 107 engages the machine 111, which is part of an overhead structure of the elevator system 101. The machine 111 is configured to control movement between the elevator car 103 and the counterweight 105. The position reference system 113 may be mounted on a fixed part at the top of the elevator shaft 117, such as on a support or guide rail, and may be configured to provide position signals related to a position of the elevator car 103 within the elevator shaft 117. In other embodiments, the position reference system 113 may be directly mounted to a moving component of the machine 111, or may be located in other positions and/or configurations as known in the art. The position reference system 113 can be any device or mechanism for monitoring a position of an elevator car and/or counter weight, as known in the art. For example, without limitation, the position reference system 113 can be an encoder, sensor, or other system and can include velocity sensing, absolute position sensing, etc., as will be appreciated by those of skill in the art.

The controller 115 is located, as shown, in a controller room 121 of the elevator shaft 117 and is configured to control the operation of the elevator system 101, and particularly the elevator car 103. For example, the controller 115 may provide drive signals to the machine 111 to control the acceleration, deceleration, leveling, stopping, etc. of the elevator car 103. The controller 115 may also be configured to receive position signals from the position reference system 113 or any other desired position reference device. When moving up or down within the elevator shaft 117 along guide rail 109, the elevator car 103 may stop at one or more landings 125 as controlled by the controller 115. Although shown in a controller room 121, those of skill in the art will appreciate that the controller 115 can be located and/or configured in other locations or positions within the elevator system 101. In one embodiment, the controller may be located remotely or in the cloud.

The machine 111 may include a motor or similar driving mechanism. In accordance with embodiments of the disclosure, the machine 111 is configured to include an electrically driven motor. The power supply for the motor may be any power source, including a power grid, which, in combination with other components, is supplied to the motor. The machine 111 may include a traction sheave that imparts force to tension member 107 to move the elevator car 103 within elevator shaft 117.

Although shown and described with a roping system including tension member 107, elevator systems that employ other methods and mechanisms of moving an elevator car within an elevator shaft may employ embodiments of the present disclosure. For example, embodiments may be employed in ropeless elevator systems using a linear motor to impart motion to an elevator car. Embodiments may also be employed in ropeless elevator systems using a hydraulic lift to impart motion to an elevator car. FIG. 1 is merely a non-limiting example presented for illustrative and explanatory purposes.

In other embodiments, the system comprises a conveyance system that moves passengers between floors and/or along a single floor. Such conveyance systems may include escalators, people movers, etc. Accordingly, embodiments described herein are not limited to elevator systems, such as that shown in Figure 1. In one example, embodiments disclosed herein may be applicable conveyance systems such as an elevator system 101 and a conveyance apparatus of the conveyance system such as an elevator car 103 of the elevator system 101. In another example, embodiments disclosed herein may be applicable conveyance systems such as an escalator system and a conveyance apparatus of the conveyance system such as a moving stair of the escalator system.

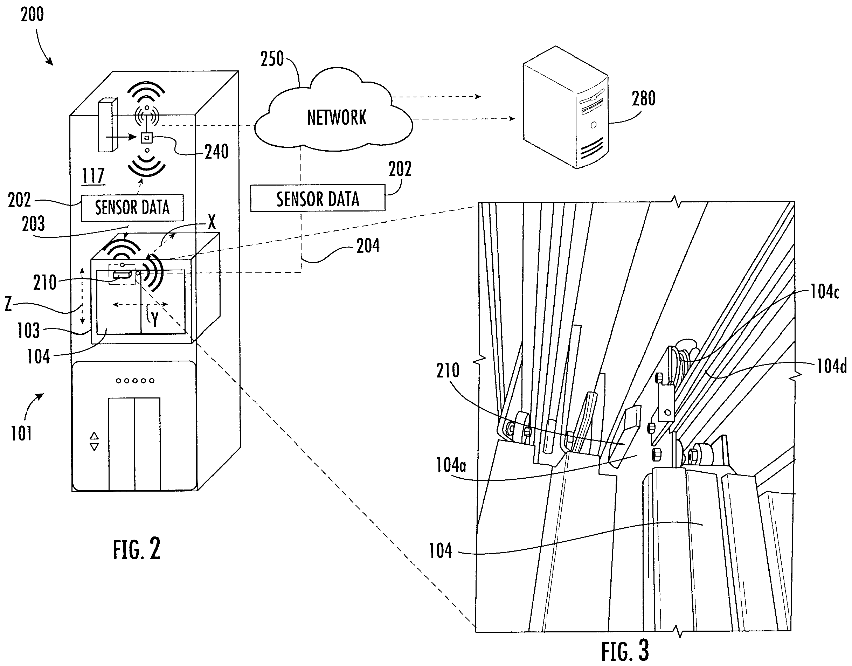

FIG. 2 is a view of a sensor system 200 including a sensing apparatus 210, according to an embodiment of the present disclosure. The sensing apparatus 210 is configured to detect sensor data 202 of the elevator car 103 and transmit the sensor data 202 to a remote device 280. Sensing data 202 may include but is not limited to accelerations and derivatives or integrals of accelerations, such as, for example, velocity, jerk, jounce, snap...etc. Sensing data 202 may also include light, pressure, sound, humidity, and temperature. In an embodiment, the sensing apparatus 210 is configured to process the sensor data 202 prior to transmitting the sensor data 202 to the remote device 280. The processing of the sensor data 202 may reveal data, such as, for example, a number of elevator door openings/closings, elevator door time, vibrations, a number of elevator rides, elevator ride performance, elevator flight time, relative and absolute car position (e.g. elevation, floor number), releveling events, rollbacks, car x, y acceleration at a position: (i.e., rail topology), door performance at a landing number, nudging event, vandalism events, emergency stops, etc. The remote device 280 may be a computing device, such as, for example, a desktop computer. The remote device 280 may also be a mobile computing device that is typically carried by a person, such as, for example a smartphone, PDA, smartwatch, tablet, laptop, etc. The end user device 280 may also be two separate devices that are synced together, such as, for example, a cellular phone and a desktop computer synced over an internet connection. The remote device 280 may also be a cloud computing network.

The sensing apparatus 210 is configured to transmit the sensor data 202 a remote device 280 via short-range wireless protocols 203 and/or long-range wireless protocols 204. Short-range wireless protocols 203 may include but are not limited to Bluetooth, Wi-Fi, HaLow (801.11ah), zWave, Zigbee, or Wireless M-Bus. In a first communication path, 203, the sensing apparatus 210 is configured to transmit the sensor data 202 to a local gateway device 240 using short-range wireless protocols 203 and the local gateway device 240 is configured to transmit the sensor data 202 to a remote device 280 through a network 250 using long-range wireless protocols 204. The network 250 may be a computing network, such as, for example, a cloud computing network, cellular network, or any other computing network known to one of skill in the art. In a second communication path, the sensing apparatus 210 is configured to transmit the sensor data 202 to a remote device 280 through a network 250 using long-range wireless protocols 204. Long-range wireless protocols 204 may include but are not limited to cellular, LTE (NB-IoT, CAT M1), LoRa, Satellite, Ingenu, or SigFox.

FIG. 2 shows a possible installation location of the sensing apparatus 210 within the elevator system 101. In an embodiment, the sensing apparatus 210 may be attached to a door 104 of the elevator car 103. Advantageously, by attaching the sensing apparatus 210 to the door 104 of the elevator car 103 the sensing apparatus 210 may detect accelerations of the elevator car 103 and the doors 104 of the elevator car 103. For example, when located on the door 104, the sensing apparatus 210 may detect when the elevator car 103 is in motion, when the elevator car 103 is slowing, when the elevator car 103 is stopping, and when the doors 104 open to allow passengers to exit and enter the elevator car 103. It is understood that the sensing apparatus 210 may also be installed in other locations other than a door 104 of the elevator system 101. The sensing apparatus 210 may be configured to detecting acceleration in any number of directions. In an embodiment, the sensing apparatus may detect accelerations in three directions, a first direction X, a second direction Y, and a third direction Z, as show in in FIG. 2. The first direction X may be perpendicular to the doors 104 of the elevator car 103, as shown in FIG. 2. The second direction Y may be parallel to the doors 104 of the elevator car 103, as shown in FIG. 2. The third direction Z may be aligned vertically parallel with the elevator shaft 117 and pull of gravity, as shown in FIG. 2.

FIG. 3 is an enlarged view of a possible installation location of the sensing apparatus 210 within the elevator system 101. As shown in FIG. 3, the sensing apparatus may be located on a door hanger 104a of the door 104 of the elevator car 103. The door hanger 104a is located proximate a top portion 104b of the door 104 proximate the guide wheels 104c that allow the door 104 to slide open and close along a guide rail 104d. Advantageously, the door hanger 104a is an easy to access area to attach the sensing apparatus 210 because the door hanger 104a is accessible when the elevator car 103 is at landing 125 and the elevator door 104 is open. Thus, installation of the sensing apparatus 210 is possible without taking special measures to take control over the elevator car 103. For example, the additional safety of an emergency door stop to hold the elevator door 104 open is not necessary as door 104 opening at landing 125 is a normal operation mode. The door hanger 104a also provides ample clearance for the sensing apparatus 210 during operation of the elevator car 103, such as, for example, door 104 opening and closing. Also, advantageously, by placing the sensing apparatus 210 on the elevator door 104 sensor data 202 including acceleration data of the door 104 may be collected. In another embodiment, the sensing apparatus 210 may also be located on a wire or machines directly to allow non-intrusive measurements of power, current, and voltage.

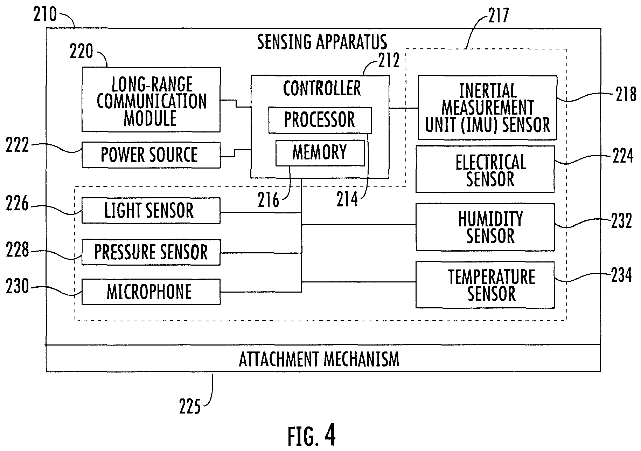

FIG. 4 illustrates a block diagram of the sensing apparatus 210 of the sensing system of FIG. 2. It should be appreciated that, although particular systems are separately defined in the schematic block diagram of FIG. 4, each or any of the systems may be otherwise combined or separated via hardware and/or software. As shown in FIG. 4, the sensing apparatus 210 may include a controller 212, one or more sensors 217 in communication with the controller 212, a communication module 220 in communication with the controller 212, and a power source 222 electrically connected to the controller 212.

The one or more sensors 217 includes an inertial measurement unit (IMU) sensor 218is configured to detect sensor data 202 of the sensing apparatus 210 and the elevator car 103 when the sensing apparatus 210 is attached to the elevator car 103. The IMU sensor 218 may be a sensor, such as, for example, an accelerometer, a gyroscope, or a similar sensor known to one of skill in the art. The sensor data 202 detected by the IMU sensor 218 may include accelerations as well as derivatives or integrals of accelerations, such as, for example, velocity, jerk, jounce, snap...etc. The IMU sensor 218 is in communication with the controller 212 of the sensing apparatus 210. The IMU sensor 218 may be a STM LIS3DH in a non-limiting embodiment. The one or more sensors 217 includes an electrical sensor 224 is configured to detect sensor data 202 including electrical data of a component of the electrical car 103. As mentioned above, the sensing apparatus 210 may also be located on a wire or machine of a component directly to allow non-intrusive measurements of power, current, and voltage using the electrical sensor 224. The electrical sensor 224 may use various electrical sensors to detect electrical data, such as, for example, Hall Effect sensors, inductive sensors, capacitive sensors, or any other electrical sensor known to one of skill in the art. The electrical sensor 224 may be a LEM ATO-75-B1I-D10 in a non-limiting embodiment.

The one or more sensors 217 may also include additional sensors including but not limited to a light sensor 226, a pressure sensor 228, a microphone 230, a humidity sensor 232, and a temperature sensor 234. The light sensor 226 is configured to detect sensor data 202 including light exposure. The light sensor 226 is in communication with the controller 212. The pressure sensor 228 is configured to detect sensor data 202 including pressure levels. The pressure sensor 228 is in communication with the controller 212. The microphone 230 is configured to detect sensor data 202 including audible sound and sound levels. The microphone 230 is in communication with the controller 212. The humidity sensor 232 is configured to detect sensor data 202 including humidity levels. The humidity sensor 232 is in communication with the controller 212. The temperature sensor 234 is configured to detect sensor data 202 including temperature levels. The temperature sensor 234 is in communication with the controller 212.

The controller 212 of the sensing apparatus 210 includes a processor 214 and an associated memory 216 comprising computer-executable instructions that, when executed by the processor 214, cause the processor 214 to perform various operations, such as, for example, processing the sensor data 202 collected by the IMU sensor 218, the electrical sensor 224, the light sensor 226, the pressure sensor 228, the microphone 230, the humidity sensor 232, and the temperature sensor 234. The processor 214 may be but is not limited to a single-processor or multi-processor system of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The memory 216 may be a storage device, such as, for example, a random access memory (RAM), read only memory (ROM), or other electronic, optical, magnetic or any other computer readable medium.

The power source 222 of the sensing apparatus 210 is configured to store and supply electrical power to the sensing apparatus 210. The power source 222 may include an energy storage system, such as, for example, a battery system, capacitor, or other energy storage system known to one of skill in the art. The power source 222 may also generate electrical power for the sensing apparatus 210. The power source 222 may also include an energy generation or electricity harvesting system, such as, for example synchronous generator, induction generator, or other type of electrical generator known to one of skill in the art.

The sensing apparatus 210 includes a communication module 220 configured to allow the controller 212 of the sensing apparatus 210 to communicate with the remote device 280 through at least one of short-range wireless protocols 203 and long-range wireless protocols 204. The communication module 220 may be configured to communicate with the remote device 280 using short-range wireless protocols 203, such as, for example, Bluetooth, Wi-Fi, HaLow (801.11ah), Wireless M-Bus, zWave, Zigbee, or other short-range wireless protocol known to one of skill in the art. Using short-range wireless protocols 203, the communication module 220 is configured to transmit the sensor data 202 to a local gateway device 240 and the local gateway device 240 is configured to transmit the sensor data to a remote device 280 through a network 250, as described above. The communication module 220 may be configured to communicate with the remote device 280 using long-range wireless protocols 204, such as for example, cellular, LTE (NB-IoT, CAT M1), LoRa, Ingenu, SigFox, Satellite, or other long-range wireless protocol known to one of skill in the art. Using long-range wireless protocols 204, the communication module 220 is configured to transmit the sensor data 202 to a remote device 280 through a network 250. In an embodiment, the short-range wireless protocol 203 is sub GHz Wireless M-Bus. In another embodiment, the long-range wireless protocol is Sigfox. In another embodiment, the long-range wireless protocol is LTE NB-IoT or CAT M1 with 2G fallback.

The sensing apparatus 210 may also include an attachment mechanism 225 configured to attach or secure the sensing apparatus 210 to the elevator car 103. The attachment mechanism 225 may be a magnet, an adhesive, a tape, a fastener (e.g., a screw), or other attachment mechanism known to one of skill in the art. In an embodiment, the attachment mechanism 225 is a magnet integrally attached to the sensing apparatus 210. The magnet enables the sensing apparatus 210 to removably attach to metal portions of the elevator car 103 such as for example, the door 104 of the elevator car 103 and/or the door hanger 104a of the door 104. Advantageously, utilizing a magnet as an attachment mechanism 225, allows the sensing apparatus 210 to be quickly attached to the elevator car 103 during installation, while also allowing for quick removal and re-attachment in other locations of the elevator car 103.

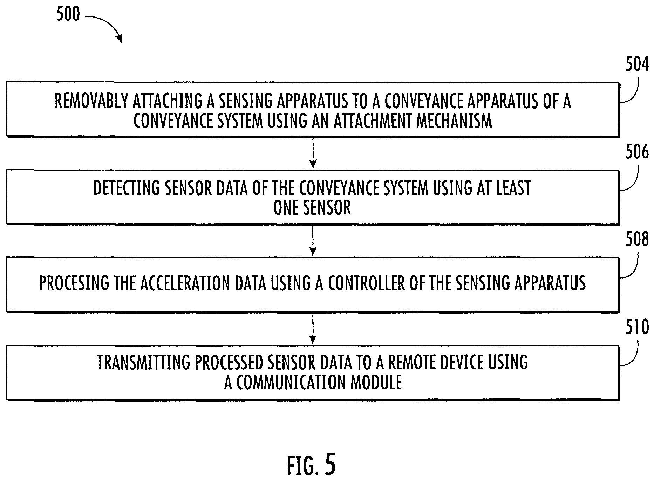

Referring now to FIG. 5, while referencing components of FIGs. 1-4. FIG. 5 shows a flow chart of a method 500 for monitoring a conveyance system, in accordance with an embodiment of the disclosure. At block 504, a sensing apparatus 210 is removably attached to a conveyance apparatus of a conveyance system using an attachment mechanism 225. In an embodiment, the conveyance apparatus may be an elevator car 103 and the conveyance system may be an elevator system 101. In another embodiment, the conveyance system may be an escalator system and the conveyance apparatus may be a moving stair of an escalator system. At block 506, sensor data 202 of the conveyance system is detected using one or more sensors 217. At block 508, the sensor data 202 is processed using a controller 212 of the sensing apparatus 210. Processing may include manipulating the raw sensor data 202 to glean useful data or information (i.e., processed sensor data 202). The processing may be different depending on the information desired from the raw sensor data 202. For example, the distance traveled or floor number detected may be calculated based upon integrating the acceleration detected. In another example, only acceleration may be considered when jerk is constant. In another example, a published floor level may be learned when the elevator car 103 has stopped and the doors 104 have opened. In another example, a published floor level may be readjusted when the elevator car 103 has stopped and the doors 104 have opened. The controller 212 may be located within the sensing apparatus 212, as shown in FIG. 4, or integrally attached to the sensing apparatus 212. At block 510, processed sensor data 202 is transmitted to a remote device 280 using a communication module 220. The method 500 may further include: detecting at least one of power, current, and voltage of a component of the conveyance system using an electrical sensor 224. As described above, the sensing apparatus 210 may need to be attached proximate electrical wires of the component of the conveyance system in order to detect at least one of power, current, and voltage of the component.

While the above description has described the flow process of FIG. 5 in a particular order, it should be appreciated that unless otherwise specifically required in the attached claims that the ordering of the steps may be varied.

The term "about" is intended to include the degree of error associated with measurement of the particular quantity and/or manufacturing tolerances based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Those of skill in the art will appreciate that various example embodiments are shown and described herein, each having certain features in the particular embodiments, but the present disclosure is not thus limited. Rather, the present disclosure can be modified to incorporate any number of variations, alterations, substitutions, combinations, sub-combinations, or equivalent arrangements not heretofore described, but which are commensurate with the scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A sensing apparatus for monitoring a conveyance system, the sensing apparatus comprising:
at least one sensor configured to detect sensor data of the conveyance system;
a controller configured to process the sensor data; and
a communication module in communication with the controller, the communication module being configured to transmit processed sensor data to a remote device.

2. The sensing apparatus of claim 1, wherein the at least one sensor further comprises:
an inertial measurement unit sensor configured to detect sensor data including at least one of power, current, and voltage of a component of the conveyance system.

3. The sensing apparatus of claim 1 or 2, further comprising:
an attachment mechanism configured to removably attach the sensing apparatus to a conveyance system.

4. The sensing apparatus of any of the preceding claims, wherein the at least one sensor further comprise:
an electrical sensor configured to detect sensor data including at least one of power, current, and voltage of a component of the conveyance system.

5. The sensing apparatus of claim 3 or 4, wherein the attachment mechanism is a magnet.

6. The sensing apparatus of any of the preceding claims, further comprising:
a power source configured to provide electrical power to the sensing apparatus or to generate power for the sensing apparatus.

7. The sensing apparatus of any of the preceding claims, wherein the communication module is configured to communicate with the remote device through a local gateway device, and wherein the communication module is configured to communicate with the local gateway device via short-range wireless protocols; and/or wherein the communication module is configured to communicate with the remote device via long-range wireless protocols.

8. A sensing system for monitoring a conveyance system, the sensing system comprising:
a conveyance apparatus of the conveyance system; and
a sensing apparatus removably attached to the conveyance apparatus, the sensing apparatus comprising:
a sensor configured to detect sensor data of the conveyance system;
a controller configured to process the sensor data; and
a communication module in communication with the controller, the communication module being configured to transmit processed sensor data to a remote device.

9. The sensing system of claim 8, wherein the at least one sensor further comprises:
an inertial measurement unit sensor configured to detect sensor data including at least one of power, current, and voltage of a component of the conveyance system.

10. The sensing system of claim 8 or 9, wherein the sensing apparatus further comprises:
an attachment mechanism configured to removably attach the sensing apparatus to a conveyance system.

11. The sensing system of any of claims 8 to 10, wherein the conveyance system is an elevator system and the conveyance apparatus is an elevator car; or wherein the conveyance system is an escalator system and the conveyance apparatus is a moving stair of the escalator system.

12. The sensing system of claim 10 or 11, wherein the attachment mechanism is configured to removably attach the sensing apparatus to a door of the elevator car of the elevator system; and/or wherein the attachment mechanism is configured to removably attach the sensing apparatus to a door hanger of a door of the elevator car of the elevator system; and/or wherein the attachment mechanism is a magnet.

13. The sensing system of any of claims 8 to 12, wherein the at least one sensor further comprises:
an electrical sensor configured to detect sensor date including at least one of power, current, and voltage of a component of the conveyance system.

14. The sensing system of any of claims 8 to 13, wherein the communication module is configured to communicate with the remote device through a local gateway device, and wherein the communication module is configured to communicate with the local gateway device via short-range wireless protocols; and/orwherein the communication module is configured to communicate with the remote device via long-range wireless protocols.

15. A method of monitoring a conveyance system, the method comprising:
removably attaching a sensing apparatus to a conveyance apparatus of a conveyance system using an attachment mechanism;
detecting sensor data of the sensing apparatus using a sensor;
processing the sensor data using a controller of the sensing apparatus; and
transmitting processed sensor data to a remote device using a communication module.
